(19) Europäisches Patentamt / European Patent Office / Office européen des brevets

(11) **EP 4 240 697 B1**

(12) **EUROPEAN PATENT SPECIFICATION**

(45) Date of publication and mention
of the grant of the patent:
**07.01.2026 Bulletin 2026/02**

(21) Application number: **21805491.4**

(22) Date of filing: **03.11.2021**

(51) International Patent Classification (IPC):
**C01G 53/00** $^{(2025.01)}$ **H01M 4/525** $^{(2010.01)}$

(52) Cooperative Patent Classification (CPC):
**C01G 53/50; H01M 4/485;** C01P 2002/52;
C01P 2002/54; C01P 2002/85; C01P 2004/03;
C01P 2004/51; C01P 2004/61; C01P 2006/40;
H01M 2004/028; Y02E 60/10

(86) International application number:
**PCT/EP2021/080432**

(87) International publication number:
**WO 2022/096473 (12.05.2022 Gazette 2022/19)**

(54) **A POSITIVE ELECTRODE ACTIVE MATERIAL FOR RECHARGEABLE BATTERIES**

POSITIVELEKTRODENAKTIVMATERIAL FÜR WIEDERAUFLADBARE BATTERIEN

MATÉRIAU ACTIF D'ÉLECTRODE POSITIVE POUR BATTERIES RECHARGEABLES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.11.2020 EP 20205588**

(43) Date of publication of application:
**13.09.2023 Bulletin 2023/37**

(73) Proprietors:
• **Umicore**
**1000 Brussels (BE)**
• **Umicore Korea Ltd.**
**Cheonan, Chungcheongnam-do 331-200 (KR)**

(72) Inventors:
• **KUMAKURA, Shinichi**
**2250 Olen (BE)**
• **KANG, JiHoon**
**Cheonan Chungcheongnam-do 331-200 (KR)**
• **YANG, TaeHyeon**
**Cheonan Chungcheongnam-do 331-200 (KR)**
• **PAULSEN, Jens Martin**
**Cheonan Chungcheongnam-do 331-200 (KR)**

(74) Representative: **Umicore RDI Patent Department
Watertorenstraat 33
2250 Olen (BE)**

(56) References cited:
**WO-A1-2016/116862 WO-A1-2019/185349**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**EP 4 240 697 B1**

**Description**

**TECHNICAL FIELD**

The present invention relates to a positive electrode active oxide material (also referred hereafter as positive electrode active material) for rechargeable batteries, in particular for solid-state battery (SSB) applications, comprising lithium, oxygen, nickel, and at least one metal selected from the group comprising manganese and cobalt.

More specifically, the invention relates to a single-crystalline positive electrode active material powder particulate positive electrode active material.

A positive electrode active material is defined as a material which is electrochemically active in a positive electrode. The active material is capable to capture and release Li ions when subjected to a voltage change over a predetermined period of time.

**BACKGROUND**

Such a single-crystalline positive electrode active material powder is already known, for example, from the document WO 2019/185349. The document WO 2019/185349 discloses a preparation process of a single-crystalline positive electrode active material powders. Said morphology is generally preferable in SSB applications since the monolithic morphology guarantees a good surface contact between the solid-state electrolyte and the positive electrode active material particles. However, undesirable side reactions at the interface of positive electrode active material particles and solid-state electrolyte deteriorate the electrochemical properties. The side reactions, such as metal dissolutions, are particularly severe in a polymer SSB that operates at a higher temperature generating unwanted high leakage capacity ($Q_{total}$).

It is an object of the present invention to provide a positive electrode active material powder for rechargeable batteries, having a reduced leakage current which enhances durability and performance of the battery cell. More specifically, it is an object of the present invention to provide positive electrode active materials for lithium ion batteries, in particular for SSB applications, having a total leaked capacity ($Q_{total}$) of at most 35 mAh/g or even of at most at most 20 mAh/g, as determined by the analytical methods of the present invention.

**SUMMARY OF THE INVENTION**

This objective is achieved by providing a positive electrode active material for rechargeable batteries according to claim 1. It is indeed observed that an improved $Q_{total}$, thus a reduced leaked capacity, is achieved in a lithium ion battery using a positive electrode active material powder according to the present invention, as illustrated by EX1 and EX2, and supported by the results provided in Table 3. EX1 teaches a positive electrode active material comprising single-crystalline particles comprising aluminum and fluorine elements, wherein an atomic ratio of Al to a total atomic content of Ni, Mn, and/or Co is 3.28, as determined by XPS analysis, and an atomic ratio of F to a total atomic content of Ni, Mn, and/or Co is 1.86, as determined by XPS analysis.

Further, the present invention provides a polymer battery comprising a positive electrode active material according to the first aspect of the invention; an electrochemical cell comprising a positive electrode active material according to the first aspect of the invention; a process for manufacturing the positive electrode active material according to the first aspect of the invention; and a use of a positive electrode active material according to the first aspect of the invention in a battery of either one of a portable computer, a tablet, a mobile phone, an electrically powered vehicle, and an energy storage system.

**DESCRIPTION OF THE FIGURES**

By means of further guidance, figures are included to better appreciate the teaching of the present invention. Said figures are intended to assist the description of the invention and are nowhere intended as a limitation of the presently disclosed invention. The figures and symbols contained therein have the meaning as commonly understood by one of ordinary skill in the art to which this invention belongs.

Figure 1 shows a Scanning Electron Microscope (SEM) image of a positive electrode active material powder according to EX1 with single-crystalline morphology.

Figure 2 shows an X-ray photoelectron spectroscopy (XPS) graphs showing the presence of Al2p peak and F1s peak in EX2 in comparison with CEX2.

Figure 3 shows the effect of the surface treatment on the $Q_{total}$ value of the positive electrode active material for EX1 and EX2 in comparison with CEX1, CEX2, CEX3A, and CEX3B. X-axis is surface treatment wherein B indicates

2

before surface treatment and A is after surface treatment.

## DETAILED DESCRIPTION OF THE INVENTION

Unless otherwise defined, all terms used in disclosing the invention, including technical and scientific terms, have the meaning as commonly understood by one of ordinary skill in the art to which this invention belongs. By means of further guidance, term definitions are included to better appreciate the teaching of the present invention. As used herein, the following terms have the following meanings:

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third," etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, "a first element," "component," "region," "layer," or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an."

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

"About" as used herein referring to a measurable value such as a parameter, an amount, a temporal duration, and the like, is meant to encompass variations of +/-20% or less, preferably +/-10% or less, more preferably +/-5% or less, even more preferably +/-1% or less, and still more preferably +/-0.1% or less of and from the specified value, in so far such variations are appropriate to perform in the disclosed invention. However, it is to be understood that the value to which the modifier "about" refers is itself also specifically disclosed.

The recitation of numerical ranges by endpoints includes all numbers and fractions subsumed within that range, as well as the recited endpoints. All percentages are to be understood as percentage by weight, abbreviated as "wt.%" or as volume per cent, abbreviated as "vol.%", unless otherwise defined or unless a different meaning is obvious to the person skilled in the art from its use and in the context wherein it is used.

## Positive electrode active material

In a first aspect, the present invention provides a positive electrode active material for rechargeable batteries, comprising lithium, nickel and at least one metal selected from the group comprising manganese and cobalt. The invention relates to positive electrode active materials wherein the particle has a single-crystalline morphology. In the context of the present invention, a single-crystalline morphology stands for a morphology of a single, primary particle having a monolithic structure or of a secondary particle consisting of less than five primary particles, each having a monolithic structure, observed in proper microscope techniques like Scanning Electron Microscope (SEM).

Said particles further comprises aluminum and fluorine, whereby said particles have an atomic ratio of Al to a total amount of Ni, Mn, and/or Co of 1.0 to 7.0. Preferably, said particles have an atomic ratio of Al to a total amount of Ni, Mn, and/or Co of 1.1 to 6.0. Such ratio is determined by XPS analysis. The XPS analysis provides atomic content of elements in an uppermost layer of a particle with a penetration depth of about 10 nm from an outer edge of the particle. The outer edge of the particle is also referred to as "surface".

More preferably, the present invention provides a positive electrode active material according to the first aspect of the invention, wherein said positive electrode active material has an atomic ratio of Al to a total atomic content of Ni, Mn, and/or Co of 1.2 to 4.5, as determined by XPS analysis. Even more preferably, the present invention provides a positive electrode active material according to the first aspect of the invention, wherein said positive electrode active material has an atomic ratio of Al to a total atomic content of Ni, Mn, and/or Co of 1.7 to 3.5, as determined by XPS analysis. Preferably, said atomic ratio is between 2.0 and 3.5, and more preferably, said atomic ratio is equal to 2.0, 2.2, 2.4, 2.6, 2.8, 3.0, 3.2, 3.4 or any value there in between.

Further, the particle has an atomic ratio of F to a total amount of Ni, Mn, and/or Co of 0.5 to 6.0. Preferably, the particle has an atomic ratio of F to a total amount of Ni, Mn, and/or Co of 0.8 to 4.5. Such ratio is also easily determined by XPS analysis. Preferably, the present invention provides a positive electrode active material according to the first aspect of the invention, wherein said positive electrode active material has an atomic ratio of F to the total atomic content of Ni, Mn, and/or Co of 0.6 to 3.0, as determined by XPS analysis. More preferably, the present invention provides a positive electrode active material according to the first aspect of the invention, wherein said positive electrode active material has an atomic ratio of F to the total atomic content of Ni, Mn, and/or Co of 1.0 to 2.5, as determined by XPS analysis. Preferably, said atomic ratio is equal to 1.2, 1.4, 1.6, 1.8, 2.0, 2.2, 2.4 or any value there in between.

Preferably, the present invention provides a positive electrode active material according to the first aspect of the invention, wherein the atomic ratio of Al to F, in said positive electrode active material is from 1.00 to 2.50, as determined by XPS. Preferably, said atomic ratio is between 1.2 and 2.2, more preferably between 1.5 and 2.0, and more preferably said Al to F ratio is equal to 1.5, 1.6, 1.7, 1.8, 1.9, 2.0, or any value there in between.

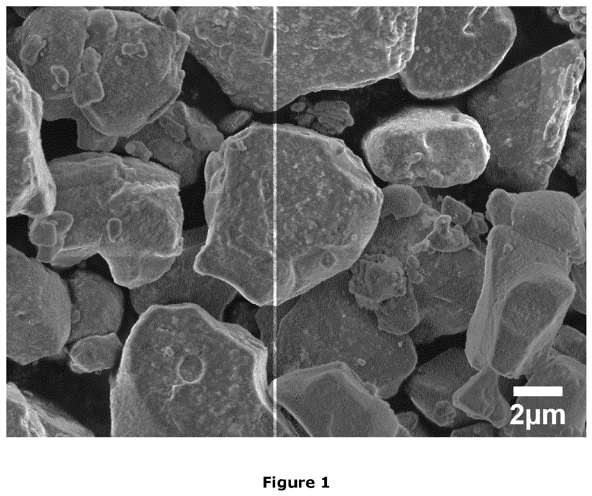

In a preferred embodiment, said positive electrode active material is comprised as a powder. Preferably, a powder is referred to as a single-crystalline powder in case 80% or more of particles in a field of view of: at least 45 $\mu$m x at least 60 $\mu$m (i.e. of at least 2700 $\mu$m$^2$), preferably of: at least 100 $\mu$m x 100 $\mu$m (i.e. of at least 10,000 $\mu$m$^2$) provided by a SEM measurement have the single-crystalline morphology. A monolithic particle, one-body particle, and mono-crystalline particle are synonyms of the single-crystalline particle. Such particles with single-crystalline morphology is shown in Figure 1.

A positive electrode active material for rechargeable batteries according to the invention indeed allow for an improved $Q_{total}$ in a lithium ion battery, thus a reduced leaked capacity. This is illustrated by EX1 and EX2 and the results provided in the Table 3. EX1 details a positive electrode active material comprising single-crystalline particles comprising aluminum and fluorine elements, wherein an atomic ratio of Al to a total atomic content of Ni, Mn, and/or Co is 3.28, as determined by XPS analysis and an atomic ratio of F to a total atomic content of Ni, Mn, and/or Co is 1.86, as determined by XPS analysis. Moreover, the inventors have determined that a synergistic effect of the combination of the presence of Al and F and the single-crystalline morphology of the particle on the $Q_{total}$ value of the positive electrode active material is achieved.

The composition of the positive electrode active material particle can be expressed as the indices a, x, y, z, a, and d in a general formula $Li_{1+a}(Ni_xMn_yCo_zA_cD_d)_{1-a}O_2$, according to the stoichiometry of the elements determined by known analysis methods, such as ICP-OES (Inductively coupled plasma - optical emission spectrometry, also referred hereafter as ICP) and IC (ion chromatography).

Preferably, the present invention provides a positive electrode active material according to the first aspect of the invention, wherein said particle has an atomic content of nickel relative to the total atomic content of Ni, Mn, and/or Co in said particle, of at least 50 %, as determined by ICP, preferably of at least 55 % or even at least 60 %. Preferably, said particle has an atomic content of nickel as described above of up to 99 %, and more preferably of up to 95 %. More preferably, said nickel content is up to 90 % or up to 85 %. Even more preferably, said particle has an atomic content of nickel of 60 to 80 %, more preferably, 60 to 75 % or even 60 to 70 %. Especially preferred, the present invention provides a positive electrode material according to the first aspect of the invention wherein said particle has an atomic content of nickel of 60, 62, 64, 66, 68, 70, 72, or 74 %, or any value there in between. In these preferred embodiments, a synergistic effect between the composition of the surface layer and the single-crystalline morphology of the positive electrode active material on $Q_{total}$ of the resulting battery is observed.

As appreciated by the skilled person, the atomic content of a given element means how many percent of all atoms in the claimed compound are atoms of said element.

Preferably, the present invention provides a positive electrode active material according to the first aspect of the invention, wherein said particle has an atomic content of cobalt, relative to the total atomic content of Ni, Mn, and/or Co in said particle, of at most 50 %, as determined by ICP, preferably of at most 30 % or even at most 20 %. Preferably, said particle has an atomic content of cobalt as described above of at least 1 %, at least 3% or even at least 5 %. The present invention provides a positive electrode material according to the first aspect of the invention wherein said particle has an atomic content of cobalt of 5, 7, 9, 11, 13, 15, 17, or 19 %, or any value there in between.

Preferably, the present invention provides a positive electrode active material according to the first aspect of the invention, wherein said particle has an atomic content of manganese, relative to the total atomic content of Ni, Mn, and/or Co in said particle, of at most 50 %, as determined by ICP, preferably of at most 30 % or even at most 20 %. Preferably, said particle has an atomic content of manganese as described above of at least 1 %, at least 3 % or even at least 5 %. The present invention provides a positive electrode material according to the first aspect of the invention wherein said particle has an atomic content of manganese of 5, 7, 9, 11, 13, 15, 17, or 19 %, or any value there in between.

The present invention provides a positive electrode active material according to the first aspect of the invention, wherein said particles comprises Al and F. The content of Al and F (hereafter referred as **A**) in said particle, relative to the total amount of nickel, cobalt, and/or manganese in said particle as measured by ICP, is preferably between 0.05 and 3.0 %, preferably between 0.5 and 2.0 %.

Preferably **A** content is equal to $A_{Al} + A_F$ wherein $A_{Al}$ is the content of Al in said positive electrode active material particles as determined by ICP measurement and $A_F$ is the content of F in said positive electrode active material particles as determined by ICP measurement. Preferably $A_{Al}$ is between 0.025 and 2.0 % and $A_F$ is between 0.025 and 2.0 %, relative to the total amount of nickel, cobalt, and/or manganese in said particle as measured by ICP.

Preferably, the present invention provides a positive electrode active material according to the first aspect of the invention, wherein said particle comprises one or more D in an amount of at most 10 %, relative to the total atomic content of Ni, Mn, and/or Co in said particle as measured by ICP, more preferably in an amount of at most 5 %. Preferably, said D is selected from: B, Ba, Ca, Mg, Al, Nb, Sr, Ti, Fe, Mo, W, and Zr, and more preferably selected from: Al, Mg, Fe, Mo, W, and Zr, and most preferably selected from: Al, Mg, W, and Zr.

Preferably, the present invention provides a positive electrode active material according to the first aspect of the invention, wherein said particle comprises a lithium, whereby a molar ratio of lithium to the total molar amount of nickel, manganese, and/or cobalt is $0.95 \leq$ Li:Me $\leq 1.10$ wherein Me is a total atomic fraction of Ni, Mn, and/or Co.

Preferably, the present invention provides a positive electrode active material according to the first aspect of the invention, wherein said particle has a median particle size (d50 or D50) of 2 $\mu$m to 9 $\mu$m, as determined by laser diffraction. The median particle size (d50 or D50) can be measured with a Malvern Mastersizer 3000. Preferably, said median particle size is between 2 $\mu$m and 8 $\mu$m, more preferably between 3 $\mu$m and 7 $\mu$m, and most preferably about 4 $\mu$m.

Preferably, the present invention provides a positive electrode active material according to the first aspect of the invention, wherein said positive electrode active material has a leaked capacity $Q_{total}$ of at most 35 mAh/g, preferably of at most 30 mAh/g, preferably of at most 25 mAh/g, and most preferably of at most 20 mAh/g. Said leaked capacity $Q_{total}$ is determined by a coin cell testing procedure at 80°C using a 1C current definition of 160 mA/g in the 4.4-3.0 V/Li metal window range. The testing procedure is further described in §1.5 and included hereby by reference.

Preferably, the present invention provides a positive electrode active material according to the first aspect of the invention comprises LiF, $LiAlO_2$, and $Al_2O_3$ as identified by XPS.

**Positive electrode**

The present invention provides a positive electrode for lithium-ion secondary batteries comprising positive electrode active material according to the first aspect of the invention and a polymer solid electrolyte. The use of such positive electrode in a SSB has a purpose to improve the capacity of SSB comprising said positive electrode active material by allowing a better interfacial contact between the positive electrode active material and the solid electrolyte.

In the framework of the present invention, said positive electrode is a mixture comprising a solid electrolyte and a positive electrode active material powder.

Preferably said positive electrode is fabricated by mixing solid electrolyte and a positive electrode active material powder in a solvent to form a slurry and casting the slurry on an aluminum foil followed by drying step to remove the solvent.

Preferably, said polymer solid electrolyte is a mixture comprises polycaprolactone and lithium bis(trifluoromethanesulfonyl)imide salt.

Preferably, said positive electrode comprising a polymer solid electrolyte and positive electrode active material powder with a ratio of polymer solid electrolyte : positive electrode active material powder is between 3:20 and 9:20, more preferably between 1:5 and 2:5, and most preferably about 7:25.

**Polymer battery**

In a second aspect, the present invention provides a polymer battery comprising a positive electrode active material according to the first aspect of the invention.

**Electrochemical cell**

In a third aspect, the present invention provides an electrochemical cell comprising a positive electrode active material according to the first aspect of the invention.

**Process**

In a fourth aspect, the present invention provides a process for manufacturing the positive electrode active material, said process comprising the steps of:

- mixing a single-crystalline, mixed metal oxide comprising lithium, nickel and at least one metal selected from the group comprising manganese and cobalt with a first Al-containing compound so as to obtain a first mixture;
- heating said first mixture at a first heating temperature of at least 500°C and at most 1000°C so as to obtain a first heat-treated mixture;
- mixing a fluorine-containing compound and a second Al-containing compound with said first heat-treated mixture so as to obtain a second mixture;
- heating said second mixture at the second heating temperature of at least 200°C and at most 500°C.

As appreciated by the skilled person, increasing the amount of the first Al-containing compound and/or the second Al-containing compound and/or the fluorine-containing compound results in a higher atomic ratio of Al and/or F as determined by XPS analysis (*i.e.* higher amounts of Al and/or F are found in the surface layer of the positive electrode material).

Preferably, the present invention provides a process according to the fourth aspect of the invention for manufacturing a positive electrode material according to the first aspect of the invention. I.e., single-crystalline, mixed metal oxide comprising lithium, nickel, and at least one metal selected from the group comprising manganese and cobalt, wherein:

- Nickel atomic content is between 50.0 % and 95 %, preferably 60.0 % and 90 %, relative to the total atomic content of Ni, Mn, and/or Co,
- Cobalt atomic content is between 5.0 % and 40 %, preferably 5.0 % and 30 %, relative to the total atomic content of Ni, Mn, and/or Co,
- Manganese atomic content is between 0.0 % and 70 %, preferably 0.5 % and 70 %, relative to the total atomic content of Ni, Mn, and/or Co,

and said manufactured positive electrode active material further comprising A and D, wherein:

- A comprising Al and F, wherein the Al atomic content is between 0.025 % and 3 %, preferably 0.5 % and 2 %, relative to the total atomic content of Ni, Mn, and/or Co, and wherein the F atomic content is between 0.025 % and 3 %, preferably 0.5 % and 2 %, relative to the total atomic content of Ni, Mn, and/or Co,
- D atomic content is between 0 % and 10 %, preferably 0.0 % and 5 %, relative to the total atomic content of Ni, Mn, and/or Co, wherein D comprising at least one element of the group consisting of: B, Ba, Ca, Mg, Al, Nb, Sr, Ti, Fe, Mo, W, and Zr, The source of D can be added in the precursor preparation or in the blending step together with lithium source. The source of D can be added, for instance, to improve the electrochemical properties of the positive electrode active material powder product,
- and wherein the atomic content is defined by ICP.

Preferably, the present invention provides a process according to the fourth aspect of the invention, wherein said first Al-containing compound is mixed with said single-crystalline lithium transition metal oxide compound, whereby said second Al-containing compound is the same as said first Al-containing compound. Preferably, the present invention provides a process according to the fourth aspect of the invention, wherein said first and/or said second Al-containing compound(s) is/are $Al_2O_3$.

Preferably, the present invention provides a process according to the fourth aspect of the invention, wherein said first and/or said second Al-containing compound comprise a nanometric alumina powder having a D50 < 100 nm and a surface area $\geq 50 m^2/g$.

Preferably, the present invention provides a process according to the fourth aspect of the invention, wherein a content of fluorine-containing polymer in said second mixture is between 0.1 and 2.0 wt.%, relative to the total weight of said second mixture. Preferably, said content of fluorine-containing polymer in said second mixture is between 0.1 and 0.5 wt.%, more preferably said content is equal to 0.2, 0.25, 0.3, 0.35, 0.4, or 0.45, or any value there in between.

Preferably, the present invention provides a process according to the fourth aspect of the invention, wherein said fluorine-containing polymer is selected from the group comprising a PVDF homopolymer, a PVDF copolymer, a PVDF-HFP polymer (hexa-fluoro propylene), and a PTFE polymer, or combinations of two or more of the aforementioned.

In a fifth aspect, the present invention provides a use of a positive electrode active material according to the first aspect of the invention in a battery of either one of a portable computer, a tablet, a mobile phone, an electrically powered vehicle, and an energy storage system.

## EXAMPLES

The following examples are intended to further clarify the present invention and are nowhere intended to limit the scope of the present invention.

## 1. Description of analysis method

### 1.1. Inductively Coupled Plasma

The composition of a positive electrode active material powder is measured by the inductively coupled plasma (ICP) method using an Agilent 720 ICP-OES (*Agilent Technologies,* https://www.agilent.com/cs/library/brochures/ 5990-6497EN%20720-725_ICP-OES_LR.pdf). 1 gram of powder sample is dissolved into 50 mL of high purity hydrochloric acid (at least 37 wt.% of HCl with respect to the total weight of solution) in an Erlenmeyer flask. The flask is covered by a watch glass and heated on a hot plate at 380°C until the powder is completely dissolved. After being cooled to room temperature, the solution from the Erlenmeyer flask is poured into a first 250 mL volumetric flask. Afterwards, the first volumetric flask is filled with deionized water up to the 250 mL mark, followed by a complete homogenization process (1st dilution). An appropriate amount of the solution from the first volumetric flask is taken out by a pipette and transferred into a second 250 mL volumetric flask for the 2nd dilution, where the second volumetric flask is filled with an internal standard element and 10% hydrochloric acid up to the 250 mL mark and then homogenized. Finally, this solution is used for ICP measurement.

### 1.2. SEM (Scanning Electron Microscope) analysis

The morphology of positive electrode active materials is analyzed by a Scanning Electron Microscopy (SEM) technique. The measurement is performed with a JEOL JSM 7100F under a high vacuum environment of $9.6 \times 10^{-5}$ Pa at 25°C.

### 1.3. Surface area analysis

The specific surface area of the powder is analyzed with the Brunauer-Emmett-Teller (BET) method using a Micromeritics Tristar 3000. A powder sample is heated at 300°C under a nitrogen ($N_2$) gas for 1 hour prior to the measurement in order to remove adsorbed species. The dried powder is put into the sample tube. The sample is then degassed at 30°C for 10 minutes. The instrument performs the nitrogen adsorption test at 77K. By obtaining the nitrogen isothermal absorption/desorption curve, the total specific surface area of the sample in $m^2/g$ is derived.

### 1.4. Particle size distribution

The particle size distribution (PSD) of the positive electrode active material powder is measured by using a Malvern Mastersizer 3000 with a Hydro MV wet dispersion accessory (https://www.malvernpanalytical.com/en/products/ product-range/mastersizer-range/mastersizer-3000#overview) after having dispersed each of the powder samples in an aqueous medium. In order to improve the dispersion of the powder, sufficient ultrasonic irradiation and stirring is applied, and an appropriate surfactant is introduced. D50 is defined as the particle size at 50% of the cumulative volume% distributions obtained from the Malvern Mastersizer 3000 with Hydro MV measurements.

### 1.5. Polymer cell test

### 1.5.1. Polymer cell preparation

### 1.5.1.1. Solid polymer electrolyte (SPE) preparation

Solid polymer electrolyte (SPE) is prepared according to the process as follows:

Step 1) Mixing polyethylene oxide (PEO having a molecular weight of 1,000,000, *Alfa Aesar* https://www.alfa.co.kr/ AlfaAesarApp/faces/adf.task-flow?adf.tfld=ProductDetailsTF&adf.tfDoc=/WEB-INF/ProductDetailsTF.xml&Produc tId=043678&_afrLoop=1010520209597576&_afrWindowM ode=0&_afrWindowId=null) with Lithium bis(trifluoromethanesulfonyl)imide salt (LiTFSI, Soulbrain Co., Ltd.) in acetonitrile anhydrous 99.8 wt.% (Aldrich https://www. sigmaaldrich.com/catalog/product/sial/271004?lang=ko&region=KR&gclid=EAI aIQobChMlwcrB0dDL6AIVBbeW Ch0ieAXREAAYASAAEgJCa_D_BwE), using a mixer for 30 minutes at 2000 revolutions per minute (rpm). The molar ratio of ethylene oxide to lithium is 20.
Step 2) Pouring the mixture from Step1) into a Teflon dish and dried in 25°C for 12 hours.
Step 3) Detaching the dried SPE from the dish and punching the dried SPE in order to obtain SPE disks having a

thickness of 300 μm and a diameter of 19 mm.

### 1.5.1.2. Catholyte electrode preparation

Catholyte electrode is prepared according to the process as follows:

Step 1) Preparing a polymer electrolyte mixture comprising polycaprolactone (PCL having a molecular weight of 80,000, *Sigma-Aldrich* https://www.sigmaaldrich.com/catalog/product/aldrich/440744) solution in anisole anhydrous 99.7 wt.% (Sigma-Aldrich, https://www.sigmaaldrich.com/catalog/product/sial/296295) and Lithium bis(trifluoromethanesulfonyl)imide salt (LiTFSI, *Sigma-Aldrich,* https://www.sigmaaldrich.com/catalog/product/aldrich/544094) in acetonitrile. The mixture has a ratio of PCL : LiTFSI of 74 : 26 by weight.
Step 2) Mixing a polymer electrolyte mixture prepared from Step 1), a positive electrode active material, and a conductor powder (Super P, *Timcal (Imerys Graphite & Carbon),* http://www.imerys-graphite-and-carbon.com/word press/wp-app/uploads/2018/10/ENSACO-150-210-240-250-260-350-360-G-ENSACO-150-250-P-SUPER-P-SU PER-P-Li-C-NERGY-SUPER-C-45-65-T_V-2.2_-USA-SDS.pdf) in acetonitrile solution with a ratio of 21 : 75 : 4 by weight so as to prepare a slurry mixture. The mixing is performed by a homogenizer for 45 minutes at 5000 rpm.
Step 3) Casting the slurry mixture from Step 2) on one side of a 20 μm-thick aluminum foil with 100 μm coater gap.
Step 4) Drying the slurry-casted foil at 30°C for 12 hours followed by punching in order to obtain catholyte electrodes having a diameter of 14 mm.

### 1.5.1.3. Polymer cell assembling

The coin-type polymer cell is assembled in an argon-filled glovebox with an order from bottom to top: a 2032 coin cell can, a catholyte electrode prepared from section 1.5.1.2, a SPE prepared from section 1.5.1.1, a gasket, a Li anode, a spacer, a wave spring, and a cell cap. Then, the coin cell is completely sealed to prevent leakage of the electrolyte.

### 1.5.2. Testing method

Each coin-type polymer cell is cycled at 80°C using a Toscat-3100 computer-controlled galvanostatic cycling stations (from *Toyo, http://www.toyosystem.com/image/menu3/toscat/TOSCAT-3100.pdf).* The coin cell testing procedure uses a 1C current definition of 160 mA/g in the 4.4-3.0 V/Li metal window range according to the schedule below:

Step 1) Charging in a constant current mode with C-rate of 0.05 with an end condition of 4.4 V followed by 10 minutes rest.
Step 2) Discharging in a constant current mode with C-rate of 0.05 with an end condition of 3.0 V followed by 10 minutes rest.
Step 3) Charging in a constant current mode with C-rate of 0.05 with an end condition of 4.4 V.
Step 4) Switching to a constant voltage mode and keeping 4.4 V for 60 hours.
Step 5) Discharging in a constant current mode with C-rate of 0.05 with an end condition of 3.0 V.

$Q_{total}$ is defined as the total leaked capacity at the high voltage and high temperature in the Step 4) according to the described testing method. A low value of $Q_{total}$ indicates a high stability of the positive electrode active material powder during a high temperature operation.

### 1.6. X-ray Photoelectron Spectroscopy (XPS)

In the present invention, X-ray photoelectron spectroscopy (XPS) is used to analyze the surface of positive electrode active material powder particles. In XPS measurement, the signal is acquired from the first few nanometers (e.g. 1 nm to 10 nm) of the uppermost part of a sample, i.e. surface layer. Therefore, all elements measured by XPS are contained in the surface layer.
For the surface analysis of positive electrode active material powder particles, XPS measurement is carried out using a Thermo K-α+ spectrometer (*Thermo Scientific, https://www.thermofisher.com/order/catalog/product/IQLAAD-GAAFFACVMAHV).* Monochromatic Al Kα radiation (hu=1486.6 eV) is used with a spot size of 400 μm and measurement angle of 45°. A wide survey scan to identify elements present at the surface is conducted at 200 eV pass energy. C1s peak having a maximum intensity (or centered) at a binding energy of 284.8 eV is used as a calibrate peak position after data collection. Accurate narrow-scans are performed afterwards at 50 eV for at least 10 scans for each identified element to determine the precise surface composition.
Curve fitting is done with CasaXPS Version2.3.19PR1.0 (*Casa Software,* http://www.casaxps.com/) using a Shirley-type background treatment and Scofield sensitivity factors. The fitting parameters are according to Table 1a. Line shape GL(30) is the Gaussian/Lorentzian product formula with 70% Gaussian line and 30% Lorentzian line. LA($\alpha$, $\beta$, m) is an asymmetric line-shape where $\alpha$ and $\beta$ define tail spreading of the peak and m define the width.

Table 1a. XPS fitting parameter for Ni2p3, Mn2p3, Co2p3, Al2p, and F1s.

| Element | Sensitivity factor | Fitting range (eV) | Defined peak(s) | Line shape |
|---|---|---|---|---|
| Ni | 14.61 | 851.1$\pm$0.1- 869.4$\pm$0.1 | Ni2p3, Ni2p3 satellite | LA(1.33, 2.44, 69) |
| Mn | 9.17 | 639.9$\pm$0.1- 649.5$\pm$0.1 | Mn2p3, Mn2p3 satellite | GL(30) |
| Co | 12.62 | 775.4$\pm$0.1- 792.8$\pm$0.1 | Co2p3, Co2p3 satellite | LA(1.33, 2.44, 69) |
| Al | 0.54 | 64.1$\pm$0.1- 78.5$\pm$0.1- | Al2p, Ni3p1, Ni3p3, Ni3p1 satellite, Ni3p3 satellite | GL(30) |
| F | 4.43 | 682.0$\pm$0.1- 688.0$\pm$0.1- | F1s | LA(1.53, 243, 1) |

For Al peak in the fitting range of 64.1$\pm$0.1 eV to 78.5$\pm$0.1, constraints are set for each defined peak according to Table 1b. Ni3p peaks are not included in the quantification. Table 1b. XPS fitting constraints for Al2p peak fitting.

| Peak | Fitting range (eV) | FWHM (eV) | Area |
|---|---|---|---|
| Al2p | 72.0-78.5 | 0.5-3.0 | No constraint set |
| Ni3p1 | 68.0-70.5 | 0.5-2.9 | 50% of Ni3p3 area |
| Ni3p3 | 65.3-68.0 | 0.5-2.9 | No constraint set |
| Ni3p1 satellite | 72.5-75.0 | 0.5-2.9 | 20% of Ni3p3 area |
| Ni3p3 satellite | 70.5-72.5 | 0.5-2.9 | 40% of Ni3p3 area |

The Al and F surface content is expressed by the atom content of Al and F, respectively, in the surface layer of the particles divided by the total content of Ni, Mn, and/or Co in said surface layer. It is calculated as follows:

$$atomic\ ratio\ of\ Al\ to\ Ni, Mn, and\ Co\ in\ the\ surface\ layer = \frac{Al\ (at.\%)}{Ni + Mn + Co\ (at.\%)}$$

$$atomic\ ratio\ of\ F\ to\ Ni, Mn, and\ Co\ in\ the\ surface\ layer = \frac{F\ (at.\%)}{Ni + Mn + Co\ (at.\%)}$$

## 2. Examples and comparative examples

**Comparative Example 1**

A single-crystalline positive electrode active material powder labelled as CEX1 having a general formula $Li_{1.01}$ $(Ni_{0.63}Mn_{0.22}Co_{0.15})_{0.99}O_2$ is obtained through a solid-state reaction between a lithium source and a nickel-based transition metal source. The process is running as follows:

Step 1) Transition metal oxidized hydroxide precursor preparation: A nickel-based transition metal oxidized hydroxide powder (TMH1) having a metal composition of $Ni_{0.63}Mn_{0.22}Co_{0.15}$ is prepared by a co-precipitation process in a large-scale continuous stirred tank reactor (CSTR) with mixed nickel manganese cobalt sulfates, sodium hydroxide, and ammonia.
Step 2) First mixing: the TMH1 prepared from Step 1) is mixed with $Li_2CO_3$ in an industrial blender so as to obtain a first mixture having a lithium to metal ratio of 0.85.

Step 3) First firing: The first mixture from Step 2) is fired at 900°C for 10 hours in dry air atmosphere so as to obtain a first fired cake. The first fired cake is grinded so as to obtain a first fired powder.

Step 4) Second mixing: the first fired powder from Step 3) is mixed with LiOH in an industrial blender so as to obtain a second mixture having a lithium to metal ratio of 1.05.

Step 5) Second firing: the second mixture from Step 4) is fired at 930°C for 10 hours in dry air, followed by a crushing (bead milling) and sieving process so as to obtain a second fired powder.

Step 6) Third mixing: the second fired powder from Step 5) is mixed with 2 mol% of Co, for example from $Co_3O_4$ powder, and 5 mol% of LiOH with respect to the total molar contents of Ni, Mn, and/or Co in an industrial blender so as to obtain a third mixture.

Step 7) Third firing: the third mixture from Step 6) is fired at 775°C for 12 hours in dry air so as to produce a third fired powder labelled as CEX1. The powder has a median particle size of 6.5 $\mu$m, as determined by laser diffraction measured with a Malvern Mastersizer 3000.

**Example 1**

A surface modified single-crystalline positive electrode active material EX1 is prepared according to the following process:

Step 1) Mixing 1 kg of the CEX1 powder with 2 grams of alumina ($Al_2O_3$) nano-powder for 30 minutes at 1000 rpm.

Step 2) Firing the mixture obtained from Step 1) in a furnace under the flow of an oxidizing atmosphere at 750°C for 10 hours.

Step 3) Mixing 1 kg powder from Step 2) with 2 grams of alumina ($Al_2O_3$) nano-powder and 3 grams of polyvinylidene fluoride (PVDF) powder for 30 minutes at 1000 rpm.

Step 4) Firing the mixture obtained from Step 3) in a furnace under the flow of oxidizing atmosphere at 375°C for 5 hours to produce a fired powder labelled as EX1. The powder has a median particle size of 6.4 $\mu$m, as determined by laser diffraction measured with a Malvern Mastersizer 3000.

**Comparative Example 2**

A single-crystalline positive electrode active material labelled as CEX2 is obtained through a solid-state reaction between a lithium source and a nickel-based transition metal source. The process is running as follows:

Step 1) Transition metal oxidized hydroxide precursor preparation: A nickel-based transition metal oxidized hydroxide powder (TMH2) having a metal composition of $Ni_{0.86}Mn_{0.07}Co_{0.07}$ is prepared by a co-precipitation process in a large-scale continuous stirred tank reactor (CSTR) with mixed nickel manganese cobalt sulfates, sodium hydroxide, and ammonia.

Step 2) Heating: the TMH2 prepared from Step 1) is heated at 400°C for 7 hours in an oxidizing atmosphere to produce a heated powder.

Step 3) First mixing: the heated powder prepared from Step 2) is mixed with LiOH in an industrial blender so as to obtain a first mixture having a lithium to metal ratio of 0.96.

Step 4) First firing: The first mixture from Step 3) is fired at 890°C for 11 hours in an oxidizing atmosphere, followed by a wet bead milling and sieving process so as to obtain a first fired powder.

Step 5) Second mixing: the first fired powder from Step4) is mixed with LiOH in an industrial blender so as to obtain a second mixture having a lithium to metal ratio of 0.99.

Step 6) Second firing: the second mixture from Step 5) is fired at 760°C for 10 hours in an oxidizing air, followed by a crushing and sieving process so as to obtain a second fired powder labelled as CEX2. The powder has a median particle size of 4.5 $\mu$m, as determined by laser diffraction measured with a Malvern Mastersizer 3000.

**Example 2**

A surface modified single-crystalline positive electrode active material EX2 is prepared according to the same method as EX1 except that CEX2 is used in the Step 1) mixing instead of CEX1. The powder has a median particle size of 4.5 $\mu$m, as determined by laser diffraction measured with a Malvern Mastersizer 3000.

**Comparative Example 3**

A polycrystalline positive electrode active material labelled as CEX3A is obtained through a solid-state reaction between a lithium source and a nickel-based transition metal source. The process is running as follows:

Step 1) Transition metal oxidized hydroxide precursor preparation: A nickel-based transition metal oxidized hydroxide powder (TMH3) having a metal composition of $Ni_{0.625}Mn_{0.175}Co_{0.20}$ and average particle size (D50) of 10.1 μm is prepared by a co-precipitation process in a large-scale continuous stirred tank reactor (CSTR) with mixed nickel manganese cobalt sulfates, sodium hydroxide, and ammonia.

Step 2) First mixing: the TMH3 prepared from Step 1) is mixed with LiOH in an industrial blender so as to obtain a first mixture having a lithium to metal ratio of 1.03.

Step 3) First firing: The first mixture from Step 2) is fired at 835°C for 10 hours in dry air atmosphere so as to obtain a first fired cake. The first fired cake is grinded so as to obtain a first fired powder.

Step 4) Second mixing: the first fired powder from Step3) is mixed with LiOH in an industrial blender so as to obtain a second mixture having a lithium to metal ratio of 1.03.

Step 5) Second firing: the second mixture from Step 4) is fired at 830°C for 10 hours in dry air, followed by a crushing and sieving process so as to obtain a second fired powder labelled as CEX3A. The powder has a median particle size of 9.1 μm, as determined by laser diffraction measured with a Malvern Mastersizer 3000.

A surface modified polycrystalline positive electrode active material CEX3B is prepared according to the same method as EX1 except that CEX3A is used in the Step 1) mixing instead of CEX1.

Table 2. Summary of the surface treatment of example and comparative examples.

| ID | Morphology | Composition [a] | | | | Element | XPS [c] | | |
|---|---|---|---|---|---|---|---|---|---|
| | | Ni/Me | Mn/Me | Co/Me | Al/Me | | Al/Me | F/Me | Al/F |
| CEX1 | single-crystalline | 0.61 | 0.22 | 0.18 | 0.000 | - b | 0.00 | 0.00 | - |
| EX1 | single-crystalline | 0.61 | 0.22 | 0.17 | 0.007 | Al, F | 3.28 | 1.86 | 1.76 |
| CEX2 | single-crystalline | 0.86 | 0.07 | 0.07 | 0.000 | - b | 0.00 | 0.00 | - |
| EX2 | single-crystalline | 0.86 | 0.07 | 0.07 | 0.007 | Al, F | 1.94 | 1.83 | 1.06 |
| CEX3A | polycrystalline | 0.63 | 0.17 | 0.20 | 0.000 | - b | 0.00 | 0.00 | - |
| CEX3B | polycrystalline | 0.63 | 0.17 | 0.20 | 0.007 | Al, F | 3.03 | 0.63 | 4.81 |

[a] as determined by ICP measurement, Me is a total atomic fraction of Ni + Mn + Co + Al.

[b] - : not applicable.

[c] as determined by XPS measurement, Me is a total atomic fraction of Ni + Mn + Co.

Table 3. Summary of the $Q_{total}$ of example and comparative examples.

| ID | $Q_{total}$ (mAh/g) |
|---|---|
| CEX1 | 39.1 |
| EX1 | 16.3 |
| CEX2 | 41.6 |
| EX2 | 32.2 |
| CEX3A | 48.2 |
| CEX3B | 36.8 |

Table 2 summarizes the examples and comparative examples composition and surface treatment. Table 3 summarizes $Q_{total}$ values of the examples and comparative examples.

Firstly, it is observed that EX1 has a significantly lower $Q_{total}$ comparing to CEX1. The same observation also obtained from EX2 and CEX3B comparing to CEX2 and CEX3A, respectively. This observation indicates that the surface modified positive electrode active material powders according to this invention have a better electrochemical performance. A low value of $Q_{total}$ indicates a high stability of the positive electrode active material powder in the high voltage application at a high temperature.

Secondly, it is observed that the surface modified positive electrode active material powder with single-crystalline morphology is more effective comparing with the polycrystalline morphology. The improvement of $Q_{total}$ from CEX1 to EX1, having a single-crystalline morphology, by the surface treatment is 58.3% while that from CEX3A to CEX3B, having a polycrystalline morphology, is 23.7%. Therefore, the synergetic effect between the surface treatment and the single-crystalline morphology is required in order to achieve the objective of this invention of $Q_{total}$ inferior to 35 mAh/g.

Thirdly, the surface treatment also works on the positive electrode active material powder having a Ni/Me content of 0.86 in EX2. The $Q_{total}$ of EX2 is 32.2 mAh/g which is much lower than $Q_{total}$ of CEX2.

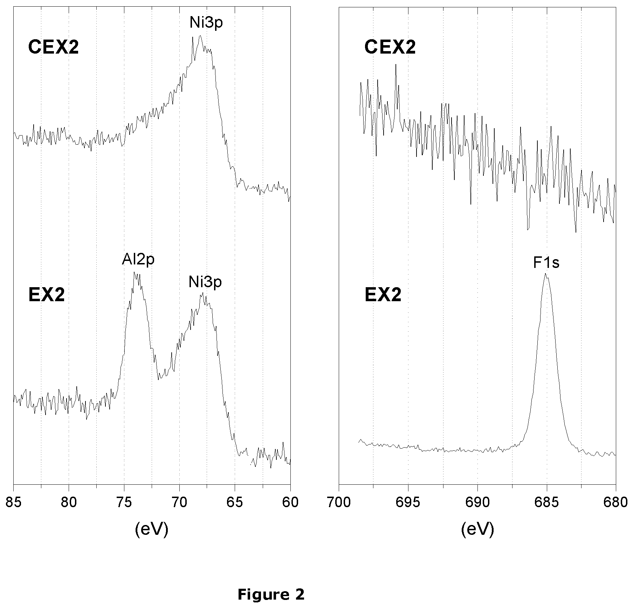

Figure 2 shows XPS spectra for Al 2p peak and F 1s peak for EX2. The Al peak located at the binding energy of around 73.8 eV corresponds to $LiAlO_2$ compound presence on the surface of the positive electrode active material (Chem. Mater. Vol. 21, No.23, 5607-5616, 2009). The F peak located at the binding energy of around 685.0 eV corresponds to LiF compound presence on the surface of the positive electrode active material (Moulder, J. F., Handbook of XPS, Perkin-Elmer, 1992).

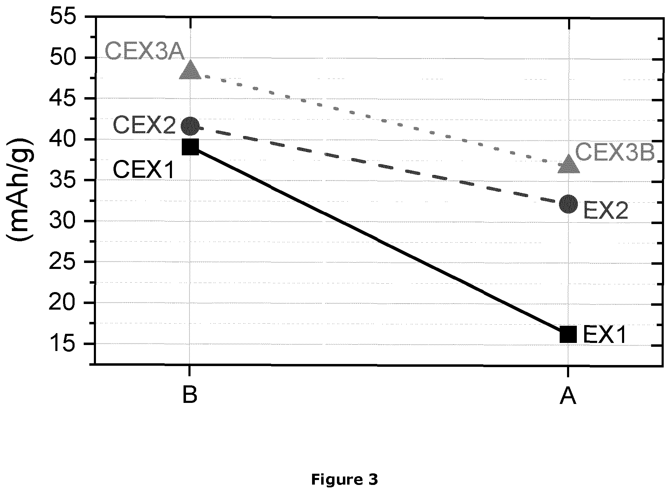

The results are graphically depicted in Figure 3 which illustrates the synergistic effect between the composition of the surface layer and the morphology of the positive electrode active material on $Q_{total}$. B and A in the x-axis indicates before surface treatment and after surface treatment, respectively.

**Claims**

1. A single-crystalline positive electrode active oxide material for rechargeable batteries, comprising lithium, oxygen, nickel, and at least one metal selected from the group comprising manganese and cobalt,
   **characterized in that** said positive electrode active material further comprises:

   i) aluminum and has an atomic ratio of Al to a total amount of Ni, Mn, and/or Co of 1.0 to 7.0, as determined by XPS analysis, and
   ii) fluorine and has an atomic ratio of F to a total amount of Ni, Mn, and/or Co of 0.5 to 6.0, as determined by XPS analysis.

2. Positive electrode active material according to claim 1,
   wherein said positive electrode active material further comprises:

   i) aluminum and has an atomic ratio of Al to a total amount of Ni, Mn, and/or Co of 1.2 to 4.5, as determined by XPS analysis, and
   ii) fluorine and has an atomic ratio of F to a total amount of Ni, Mn, and/or Co of 0.6 to 3.0, as determined by XPS analysis.

3. Positive electrode active material according to claim 1 or 2, wherein said positive electrode active material has an atomic ratio of Al to a total amount of Ni, Mn, and/or Co of 1.7 to 3.5, as determined by XPS analysis.

4. Positive electrode active material according to any of claims 1 to 3, wherein said positive electrode active material has an atomic ratio of F to a total amount of Ni, Mn, and/or Co of 1.5 to 2.5, as determined by XPS analysis.

5. Positive electrode active material according to any of claims 1 to 4, wherein said particles have an atomic content of nickel, relative to the total atomic content of Ni, Mn, Co in said particles, of 50 to 95 %, preferably of 60 to 85 %, as determined by ICP.

6. Positive electrode active material according to any of claims 1 to 5, wherein said particles have an atomic content of Al, relative to the total atomic content of Ni, Mn, Co in said particles, of 0.05 to 3.00 %, as determined by ICP.

7. Positive electrode active material according to any of claims 1 to 6, wherein said particles have an atomic content of Co, relative to the total atomic content of Ni, Mn, Co in said particles, of 5.00 to 25.00 %, as determined by ICP.

8. Positive electrode active material according to any of claims 1 to 7, wherein said particles have an atomic content of Mn, relative to the total atomic content of Ni, Mn, Co in said particles, of 0.00 to 70.00 %, as determined by ICP.

9. Positive electrode active material according to any of claims 1 to 8, wherein said particle has a median particle size d50 of 2 μm to 9 μm, as determined by laser diffraction.

10. Positive electrode for lithium-ion secondary batteries comprising positive electrode active material and a polymer solid electrolyte, wherein said positive electrode active material is according to any claims 1 to 9. Preferably, the polymer solid electrolyte comprises polycaprolactone.

11. A polymer battery comprising a positive electrode active material according to any of claims 1 to 9

12. An electrochemical cell comprising a positive electrode active material according to any of claims 1 to 9.

13. A process for manufacturing the positive electrode active material according to any one of claims 1-9 comprising the steps of:

> - mixing a single-crystalline, mixed metal oxide comprising lithium, nickel and at least one metal selected from the group comprising manganese and cobalt with a first Al-containing compound so as to obtain a first mixture;
> - heating said first mixture at a first heating temperature of at least 500°C and at most 1000°C so as to obtain a first heat-treated mixture;
> - mixing a fluorine-containing compound and a second Al-containing compound with said first heat-treated mixture so as to obtain a second mixture;
> - heating said second mixture at the second heating temperature of at least 200°C and at most 500°C.

14. Use of a positive electrode active material according to any of claims 1 to 9 in a battery of either one of a portable computer, a tablet, a mobile phone, an electrically powered vehicle and an energy storage system.

**Patentansprüche**

1. Einkristallines Positivelektroden-Aktivoxidmaterial für wiederaufladbare Batterien, umfassend Lithium, Sauerstoff, Nickel und mindestens ein Metall, das ausgewählt ist aus der Gruppe, die Mangan und Cobalt umfasst, **dadurch gekennzeichnet, dass** das Positivelektroden-Aktivmaterial ferner Folgendes umfasst:

> i) Aluminium, und es ein Atomverhältnis von Al zu einer Gesamtmenge an Ni, Mn und/oder Co von 1,0 bis 7,0, wie durch XPS-Analyse ermittelt, aufweist, und
> ii) Fluor, und es ein Atomverhältnis von F zu einer Gesamtmenge an Ni, Mn und/oder Co von 0,5 bis 6,0, wie durch XPS-Analyse ermittelt, aufweist.

2. Positivelektroden-Aktivmaterial nach Anspruch 1, wobei das Positivelektroden-Aktivmaterial ferner Folgendes umfasst:

> i) Aluminium, und es ein Atomverhältnis von Al zu einer Gesamtmenge an Ni, Mn und/oder Co von 1,2 bis 4,5, wie durch XPS-Analyse ermittelt, aufweist, und
> ii) Fluor, und es ein Atomverhältnis von F zu einer Gesamtmenge an Ni, Mn und/oder Co von 0,6 bis 3,0, wie durch XPS-Analyse ermittelt, aufweist.

3. Positivelektroden-Aktivmaterial nach Anspruch 1 oder 2, wobei das Positivelektroden-Aktivmaterial ein Atomverhältnis von Al zu einer Gesamtmenge an Ni, Mn und/oder Co von 1,7 bis 3,5, wie durch XPS-Analyse ermittelt, aufweist.

4. Positivelektroden-Aktivmaterial nach einem der Ansprüche 1 bis 3, wobei das Positivelektroden-Aktivmaterial ein Atomverhältnis von Al zu einer Gesamtmenge an Ni, Mn und/oder Co von 1,5 bis 2,5, wie durch XPS-Analyse ermittelt, aufweist.

5. Positivelektroden-Aktivmaterial nach einem der Ansprüche 1 bis 4, wobei die Teilchen einen Atomgehalt von Nickel, bezogen auf den Gesamtatomgehalt von Ni, Mn, Co in den Teilchen, von 50 bis 95 %, vorzugsweise von 60 bis 85 %, wie durch ICP ermittelt, aufweisen.

6. Positivelektroden-Aktivmaterial nach einem der Ansprüche 1 bis 5, wobei die Teilchen einen Atomgehalt von Al, bezogen auf den Gesamtatomgehalt von Ni, Mn, Co in den Teilchen, von 0,05 bis 3,00 %, wie durch ICP ermittelt, aufweisen.

7. Positivelektroden-Aktivmaterial nach einem der Ansprüche 1 bis 6, wobei die Teilchen einen Atomgehalt von Co, bezogen auf den Gesamtatomgehalt von Ni, Mn, Co in den Teilchen, von 5,00 bis 25,00 %, wie durch ICP ermittelt, aufweisen.

8. Positivelektroden-Aktivmaterial nach einem der Ansprüche 1 bis 7, wobei die Teilchen einen Atomgehalt von Mn, bezogen auf den Gesamtatomgehalt von Ni, Mn, Co in den Teilchen, von 0,00 bis 70,00 %, wie durch ICP ermittelt, aufweisen.

**9.** Positivelektroden-Aktivmaterial nach einem der Ansprüche 1 bis 8, wobei das Teilchen eine mittlere Teilchengröße d50 von 2 $\mu$m bis 9 $\mu$m, wie durch Laserbeugung ermittelt, aufweist.

**10.** Positivelektrode für Lithium-Ionen-Sekundärbatterien, das Positivelektroden-Aktivmaterial und einen Polymer-Festelektrolyt umfasst, wobei das Positivelektroden-Aktivmaterial einem der Ansprüche 1 bis 9 entspricht, wobei der Polymer-Festelektrolyt vorzugsweise Polycaprolacton umfasst.

**11.** Polymerbatterie, umfassend ein Positivelektroden-Aktivmaterial nach einem der Ansprüche 1 bis 9.

**12.** Elektrochemische Zelle, umfassend ein Positivelektroden-Aktivmaterial nach einem der Ansprüche 1 bis 9.

**13.** Verfahren zur Herstellung eines Positivelektroden-Aktivmaterials nach einem der Ansprüche 1-9, umfassend die Schritte:

- Mischen eines einkristallinen Mischmetalloxids, das Lithium, Nickel und mindestens ein Metall umfasst, das ausgewählt ist aus der Gruppe, die Mangan und Cobalt umfasst, mit einer ersten Al-haltigen Verbindung, um ein erstes Gemisch zu erhalten;
- Erwärmen des ersten Gemischs bei einer ersten Erwärmungstemperatur von mindestens 500 °C und höchstens 1000 °C, um ein erstes wärmebehandeltes Gemisch zu erhalten;
- Mischen einer fluorhaltigen Verbindung und einer zweiten Al-haltigen Verbindung mit dem ersten wärmebehandelten Gemisch, um ein zweites Gemisch zu erhalten;
- Erwärmen des zweiten Gemischs bei der zweiten Erwärmungstemperatur von mindestens 200 °C und höchstens 500 °C.

**14.** Verwendung eines Positivelektroden-Aktivmaterials nach einem der Ansprüche 1 bis 9 in einer Batterie von einem von einem tragbaren Computer, einem Tablet, einem Mobiltelefon, einem elektrisch betriebenen Fahrzeug und einem Energiespeichersystem.

## Revendications

**1.** Matériau d'oxyde actif d'électrode positive monocristallin pour batteries rechargeables, comprenant du lithium, de l'oxygène, du nickel et au moins un métal choisi dans le groupe comprenant le manganèse et le cobalt, **caractérisé en ce que** ledit matériau actif d'électrode positive comprend en outre :

i) l'aluminium et a un rapport atomique de Al à une quantité totale de Ni, Mn et/ou Co de 1,0 à 7,0, tel que déterminé par analyse XPS, et
ii) fluorine et présente un rapport atomique de F à une quantité totale de Ni, Mn et/ou Co de 0,5 à 6,0, tel que déterminé par analyse XPS.

**2.** Matériau actif d'électrode positive selon la revendication 1, dans lequel ledit matériau actif d'électrode positive comprend en outre :

i) l'aluminium et a un rapport atomique de Al à une quantité totale de Ni, Mn et/ou Co de 1,2 à 4,5, tel que déterminé par analyse XPS, et
ii) fluorine et présente un rapport atomique de F à une quantité totale de Ni, Mn et/ou Co de 0,6 à 3,0, tel que déterminé par analyse XPS.

**3.** Matériau actif d'électrode positive selon la revendication 1 ou 2, dans lequel ledit matériau actif d'électrode positive a un rapport atomique de Al à une quantité totale de Ni, Mn et/ou Co de 1,7 à 3,5, tel que déterminé par analyse XPS.

**4.** Matériau actif d'électrode positive selon l'une quelconque des revendications 1 à 3, dans lequel ledit matériau actif d'électrode positive a un rapport atomique de F à une quantité totale de Ni, Mn et/ou Co de 1,5 à 2,5, tel que déterminé par analyse XPS.

**5.** Matière active d'électrode positive selon l'une quelconque des revendications 1 à 4, dans laquelle lesdites particules ont une teneur atomique en nickel, par rapport à la teneur atomique totale en Ni, Mn, Co dans lesdites particules, de 50 à 95 %, de préférence de 60 à 85 %, telle que déterminée par ICP.

6. Matière active d'électrode positive selon l'une quelconque des revendications 1 à 5, dans laquelle lesdites particules ont une teneur atomique en Al, par rapport à la teneur atomique totale en Ni, Mn, Co dans lesdites particules, de 0,05 à 3,00 %, telle que déterminée par ICP.

7. Matière active d'électrode positive selon l'une quelconque des revendications 1 à 6, dans laquelle lesdites particules ont une teneur atomique en Co, par rapport à la teneur atomique totale en Ni, Mn, Co dans lesdites particules, de 5,00 à 25,00 %, telle que déterminée par ICP.

8. Matière active d'électrode positive selon l'une quelconque des revendications 1 à 7, dans laquelle lesdites particules ont une teneur atomique en Mn, par rapport à la teneur atomique totale en Ni, Mn, Co dans lesdites particules, de 0,00 à 70,00 %, telle que déterminée par ICP.

9. Matière active d'électrode positive selon l'une quelconque des revendications 1 à 8, dans laquelle ladite particule a une taille moyenne de particule d50 de 2 $\mu$m à 9 $\mu$m, telle que déterminée par diffraction laser.

10. Électrode positive pour batteries secondaires lithium-ion comprenant un matériau actif d'électrode positive et un électrolyte solide polymère, dans laquelle ledit matériau actif d'électrode positive est selon l'une quelconque des revendications 1 à 9. De préférence, l'électrolyte solide polymère comprend de la polycaprolactone.

11. Batterie polymère comprenant le matériau actif d'électrode positive selon l'une quelconque des revendications 1 à 9.

12. Cellule électrochimique comprenant le matériau actif d'électrode positive selon l'une quelconque des revendications 1 à 9.

13. Procédé de fabrication du matériau actif d'électrode positive selon l'une quelconque des revendications 1 à 9, comprenant les étapes consistant à :

- mélanger un oxyde métallique mixte monocristallin comprenant du lithium, du nickel et l'au moins un métal choisi dans le groupe comprenant le manganèse et le cobalt avec un premier composé contenant de l'Al de manière à obtenir un premier mélange ;
- chauffer ledit premier mélange à une première température de chauffage d'au moins 500°C et d'au plus 1000°C de manière à obtenir un premier mélange traité thermiquement ;
- mélanger un composé contenant du fluor et d'un deuxième composé contenant de l'Al avec ledit premier mélange traité thermiquement de manière à obtenir un deuxième mélange ;
- chauffer ledit deuxième mélange à la deuxième température de chauffage d'au moins 200°C et d'au plus 500°C.

14. Utiliser un matériau actif d'électrode positive selon l'une quelconque des revendications 1 à 9 dans une batterie d'un ordinateur portable, d'une tablette, d'un téléphone mobile, d'un véhicule alimenté électriquement et d'un système de stockage d'énergie.

**Figure 1**

**Figure 2**

Figure 3

**REFERENCES CITED IN THE DESCRIPTION**

**Patent documents cited in the description**

- WO 2019185349 A

**Non-patent literature cited in the description**

- *Chem. Mater.*, 2009, vol. 21 (23), 5607-5616
- **MOULDER, J. F.** Handbook of XPS. Perkin-Elmer, 1992